# FASCICULE DE BREVET EUROPEEN

(11) **EP 2 975 646 B1**
(45) Date de publication et mention de la délivrance du brevet: **10.05.2017**
(21) Numéro de dépôt: 15177074.0
(22) Date de dépôt: 16.07.2015
(51) Int. Cl.: H01L 29/66, H01L 29/786, H01L 29/78

(54) **PROCEDE DE FABRICATION D'UN TRANSISTOR DANS LEQUEL LE NIVEAU DE CONTRAINTE APPLIQUE AU CANAL EST AUGMENTE**
HERSTELLUNGSVERFAHREN EINES TRANSISTORS, IN DEM DAS AN DEN KANAL ANGELEGTE SPANNUNGSNIVEAU ERHÖHT IST
METHOD FOR MANUFACTURING A TRANSISTOR IN WHICH THE LEVEL OF STRESS APPLIED TO THE CHANNEL IS INCREASED

(30) Priorité: 18.07.2014 FR 1456936
(43) Date de publication de la demande: 20.01.2016
(73) Titulaire: Commissariat à l'Énergie Atomique et aux Énergies Alternatives, 75015 Paris (FR)
(72) Inventeur: BATUDE, Perrine, 21000 DIJON (FR); MAZEN, Frédéric, 38120 SAINT EGREVE (FR); REBOH, Shay, 38054 GRENOBLE (FR); SKLENARD, Benoit, 38100 GRENOBLE (FR)
(74) Mandataire: Brevalex

(56) Documents cités:
- US-A1- 2007 045 729
- US-A1- 2008 070 370
- US-A1- 2010 193 882
- US-A1- 2012 068 193
- US-A1- 2013 137 243
- US-A1- 2014 099 763

## Description

### DOMAINE TECHNIQUE ET ÉTAT DE LA TECHNIQUE ANTÉRIEURE

La présente invention se rapporte à un procédé de fabrication de transistors dans le domaine de la microélectronique, plus particulièrement un procédé dans lequel le niveau de contrainte appliqué au canal du transistor est augmenté.

Afin d'améliorer les performances des transistors, il est connu d'appliquer une contrainte au matériau semi-conducteur formant le canal. Dans le cas d'un transistor de type N, une contrainte de traction, également désignée contrainte tensile, est appliquée et dans le cas d'un transistor de type P une contrainte compressive est appliquée.

Cette contrainte est générée en réalisant les régions de source et de drain dans un matériau qui présente soit un paramètre de maille inférieur à celui du matériau du canal pour obtenir une contrainte tensile soit un paramètre de maille supérieur à celui du matériau du canal pour obtenir une contrainte compressive. Le matériau des régions de source et de drain est réalisé par épitaxie sur une couche dans laquelle est formé le canal.

Un tel procédé est par exemple décrit dans le document "IEDM 2003 p228 High Performance UTBB FDSOI Devices Featuring 20nm gate Length for 14nm Node and Beyond "by Q. Liu *et al.* Un autre exemple est fourni par le document US2010/193882 A1.

Par exemple, dans le cas d'un canal en silicium, une épitaxie de SiGe permet d'appliquer un contrainte compressive dans le canal et une épitaxie de SiC permet d'appliquer une contrainte tensile. Dans ce dernier cas, la quantité de carbone substitutionnel incorporée est limitée à environ 1%, ce qui limite la contrainte tensile pouvant être appliquée.

### EXPOSÉ DE L'INVENTION

C'est par conséquent un but de la présente invention d'offrir un procédé de fabrication de transistors permettant d'appliquer des contraintes, notamment tensiles plus importantes, que celles obtenues par les procédés de l'état de la technique.

Le but précédemment énoncé est atteint par un procédé de fabrication de transistor comportant:
- une étape de formation par épitaxie de zones destinées à former en partie des blocs de source et de drain sur la couche comportant le canal, dans un matériau présentant un paramètre de maille inférieur à celui du matériau du canal dans le cas où l'on souhaite appliquer une contrainte compressive et un matériau présentant un paramètre de maille supérieur à celui du matériau du canal dans le cas où l'on souhaite appliquer une contrainte tensile,
- une étape d'amorphisation partielle des sources et drain de manière à ne laisser qu'une couche cristalline en haut de l'accès. La couche cristalline résiduelle des accès est séparée par une région amorphe de la zone du canal restée cristalline du fait de la protection accordée par la grille, et
- une étape de recristallisation de sorte que la couche cristalline des accès restante impose majoritairement son paramètre de maille à la couche contenant le canal.

Grâce à l'invention il est possible de réaliser des zones destinées à former les blocs de source et de drain en SiGe pour appliquer une contrainte tensile au canal en silicium. Il est alors possible d'appliquer des contraintes supérieures à celles obtenues par exemple par une épitaxie de SiC.

En d'autres termes, on isole un germe cristallin dans les zones épitaxiées destinées à former les blocs de source et de drain, celui-ci présentant un paramètre de maille différent de celui du matériau de la zone de canal; le germe peut alors se relaxer et retrouver son paramètre de maille propre. Ensuite, on effectue une recristallisation dans des conditions telles que ce soit le paramètre de maille du germe cristallin qui s'impose de manière prédominante dans les zones de source et de drain.

De manière très avantageuse on peut réaliser à partir d'une même épitaxie de SiGe les transistors de type N avec le procédé selon l'invention et de type P directement selon le procédé de l'état de la technique.

Le procédé de fabrication des transistors est alors sensiblement simplifié puisque la protection requise lors des différentes étapes pendant la réalisation de l'une ou l'autre des épitaxies n'est plus requise.

Avantageusement, on favorise la vitesse d'avancement du front de recristallisation du germe cristallin par rapport au front de recristallisation de la zone de canal en choisissant une orientation cristalline favorisant la direction du front de recristallisation du germe cristallin. L'implantation de dopants dans les zones de source et de drain peut permettre également de favoriser la vitesse d'avancement du front de recristallisation du germe cristallin.

La présente invention a alors pour objet un procédé de réalisation d'un transistor sur une couche en un premier matériau semi-conducteur cristallin pour la réalisation d'un canal, déposée sur une couche de diélectrique, le procédé comportant les étapes:
a) de croissance par au moins une épitaxie de zones en un deuxième matériau semi-conducteur sur la couche en un premier matériau semi-conducteur cristallin, de sorte à former des blocs de source et de drain avec la couche en un premier matériau semi-conducteur cristallin de part et d'autre du canal, le deuxième matériau semi-conducteur ayant un paramètre de maille différent de celui du premier matériau semi-conducteur,
b) amorphisation en profondeur d'une partie des zones en un deuxième matériau semi-conducteur de sorte à ne conserver qu'une couche de deuxième matériau semi-conducteur cristallin en surface des blocs de source et de drain, et amorphisation d'au moins les zones de la couche en un premier matériau semi-conducteur situées sous les zones en deuxième matériau semi-conducteur,
c) recristallisation des blocs de source et de drain de sorte que le deuxième matériau semi-conducteur impose son paramètre de maille aux zones de source et de drain.

Dans un exemple avantageux, l'orientation cristalline de la couche en un premier matériau semi-conducteur est <100>.

Le procédé de réalisation d'un transistor peut comporter une étape de réalisation d'une grille sur la couche en un premier matériau semi-conducteur et d'espaceurs entre la grille et les zones en un deuxième matériau semi-conducteur, lors de l'étape d'amorphisation des zones de la couche en un premier matériau semi-conducteur, les zones en un premier matériau semi-conducteur situées sous les espaceurs étant également rendues amorphes.

Une étape de dopage peut avantageusement avoir lieu avant, pendant ou après l'étape d'amorphisation et avant l'étape de recristallisation. Le ou les dopants peuvent être choisis parmi le phosphore, l'arsenic, l'antimoine et le bore.

Par exemple, la température de recristallisation de l'étape c) est comprise entre 400°C et 600°C.

L'épaisseur des zones amorphes en un deuxième matériau semi-conducteur est de préférence comprise entre 1 nm et 2 nm.

Selon un exemple, le transistor réalisé est un transistor de type N et le deuxième matériau semi-conducteur a un paramètre de maille plus grand que celui du premier matériau semi-conducteur. Le premier matériau semi-conducteur peut alors être du Si et le deuxième matériau semi-conducteur peut être du SiₓGe_{y}.

Dans un mode particulièrement avantageux, Lors de l'étape a) deux sous-étapes de croissance par épitaxie ont lieu, une première sous-étape de croissance lors de laquelle une première portion de Siₓ₁Ge_{y1} est formée, et une deuxième sous-étape lors de laquelle une deuxième portion de Siₓ₂Ge_{y2} est formée, y1 étant supérieure à y2, et dans lequel, lors de l'étape b), pour une dose donnée et une température donnée, lors de l'étape b), au moins les zones de la couche en silicium situées sous les zones en Siₓ₁Ge_{y1} sont amorphisées et y1 et y2 sont choisis de sorte que seule la première portion de Siₓ₁Ge_{y1} parmi les première Siₓ₁Ge_{y1} et deuxième portions Siₓ₂Ge_{y2} soit amorphisée.

Selon un autre exemple, le transistor réalisé est un transistor de type P et dans lequel le deuxième matériau semi-conducteur a un paramètre de maille plus petit que celui du premier matériau semi-conducteur.

Le premier matériau et le deuxième matériau peuvent être des semi-conducteurs III-V, par exemple en InGaAs.

La couche en un premier matériau semi-conducteur et la couche en un matériau diélectrique peuvent appartenir à un substrat SOI.

Le transistor à réaliser peut être un FDSOI, par exemple un FinFet.

La présente invention a également pour objet un procédé de réalisation de plusieurs transistors séparés par des barrières isolantes électriques, dans lequel les transistors sont réalisés suivant le procédé selon l'invention, et dans lequel la face libre des matériaux des barrières isolantes électriques est abaissée de sorte à réduire le contact entre les barrières isolantes électrique et les zones en un deuxième matériau semi-conducteur.

La présente invention a également pour objet un procédé de réalisation d'un ensemble de transistors de type N et de type P, dans lequel la réalisation des transistors de type N est faite selon le procédé selon l'invention et dans lequel lors de la réalisation des transistors de type P, les blocs de source et de drain sont obtenus directement par croissance par épitaxie du deuxième matériau semi-conducteur simultanément à l'étape de croissance par épitaxie du deuxième matériau semi-conducteur du procédé de réalisation des transistors de type N.

La présente invention a également pour objet un procédé de réalisation d'un ensemble de transistors de type N et de type P, dans lequel la réalisation des transistors de type P est faite selon le procédé selon l'invention et dans lequel lors de la réalisation des transistors de type N, les blocs de source et de drain sont obtenus directement par croissance par épitaxie du deuxième matériau semi-conducteur simultanément à l'étape de croissance par épitaxie du deuxième matériau semi-conducteur du procédé de réalisation des transistors de type P.

### BRÈVE DESCRIPTION DES DESSINS

La présente invention sera mieux comprise sur la base de la description qui va suivre et des dessins en annexe sur lesquels:
- les figures 1A à 1D sont des représentations schématiques d'étapes d'un procédé selon un exemple de réalisation de l'invention,
- les figures 2A à 2C sont des représentations schématiques d'étapes d'un procédé de réalisation d'un FinFet selon un exemple de réalisation de l'invention,
- la figure 3 est une vue de dessus du Finfet des figures 2A à 2C.

### EXPOSÉ DÉTAILLÉ DE MODES DE RÉALISATION PARTICULIERS

Nous allons décrire un procédé de fabrication de transistors dans lequel on souhaite appliquer une contrainte tensile au canal afin de réaliser un transistor de type N.

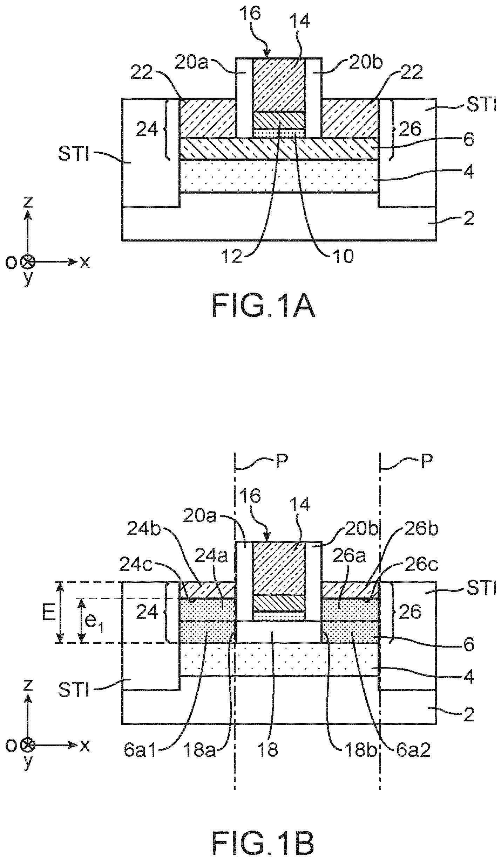

Sur la figure 1A, on peut voir représenté un exemple d'un transistor.

Le transistor comporte un substrat 2 sur lequel une couche en matériau diélectrique, par exemple en oxyde 4, est formée, il s'agit par exemple de type BOX (BOX pour "Buried oxyde"), ayant une épaisseur exemple de l'ordre 20 nm.

Une couche en matériau semi-conducteur 6 à base de matériau cristallin, du silicium dans l'exemple décrit, est formée sur la couche diélectrique 4 et en contact avec celle-ci. La couche semi-conductrice 6 peut être d'épaisseur comprise par exemple entre 3 nm et 50 nm, par exemple de l'ordre 6 nm.

Le substrat 2, la couche d'oxyde 4 et la couche de Si 6 peuvent formés un substrat de type SOI (Silicon on Insulator).

Une grille 8 est formée sur la couche 6. Pour cela des étapes de dépôt d'une couche de diélectrique 10 de grille, par exemple en oxyde, et d'une ou plusieurs couches 12, 14 de matériau(x) de grille, puis de gravure de ces couches afin de réaliser un motif de grille 16 en regard d'une zone 18 de la couche semi-conductrice 6 destinée à former un canal pour le transistor, sont effectuées. La grille 16 du transistor peut être formée d'un empilement comprenant une couche métallique 12, par exemple à base de TiN, sur laquelle repose une couche semi-conductrice 14, par exemple à base de polysilicium.

Des espaceurs isolants 20a, 20b, par exemple à base de SiₓN_{y} sont également formés contre les flancs latéraux de la grille 16, et reposent sur la couche semi-conductrice 6.

Puis, on fait croître du matériau semi-conducteur cristallin 22 par épitaxie sur la couche semi-conductrice 6, afin de former avec cette couche semi-conductrice 6, des blocs 24, 26 semi-conducteurs cristallins destinés à former des régions de source et de drain surélevées à base de matériau semi-conducteur cristallin disposées de part et d'autre de la zone 18 de canal et des espaceurs 20a, 20b. L'épaisseur de matériau semi-conducteur 22 que l'on fait croitre peut être par exemple de l'ordre de 16 nm.

Par « surélevé(e)s » on entend que les blocs 24, 26, qui, comme la zone 18 de canal, reposent sur la couche isolante 4, s'étendent au-dessus de la couche semi-conductrice 6 et ont ainsi une épaisseur supérieure à celle de la zone 18 de canal. L'épaisseur E (mesurée dans la direction de l'axe z du repère orthogonal [O,x,y,z]) des blocs 24, 26 peut être par exemple de l'ordre de 21 nm (figure 1A).

Dans cet exemple, le matériau semi-conducteur 22 est du Si_{w}Ge_{z} qui présente un paramètre de maille supérieur à celui du silicium. A des fins de simplicité le Si_{w}Ge_{z} sera désigné SiGe dans la suite de la demande. Le SiGe contient par exemple environ 30% de Ge.

Lors de la croissance par épitaxie, le SiGe croît suivant le paramètre de maille du silicium et applique alors à la zone de canal 18 une contrainte compressive.

On applique ensuite aux régions 24, 26 une étape d'amorphisation en profondeur ou enterrée partielle de sorte à former en profondeur des zones 24a, 26a de matériau amorphe à partir des régions 24 et 26 et des régions 6a1, 6a2 de matériau amorphe dans la couche 6 et de sorte à conserver une couche de matériau cristallin 24b, 26b au niveau de la partie supérieure libre des régions 24, 26 ou en haut de l'accès. Ces couches de matériau cristallin restantes forment un germe cristallin pour la recristallisation ultérieure.

L'amorphisation enterrée peut être réalisée par exemple selon des conditions telles que décrites dans le document Signamarcheix T. et al., « Fully depleted silicon on insulator MOSFETs on (110) surface for hybrid orientation technologies » Solid-State Electronics Volume 59, Issue 1, May 2011*.* Dans ce document, l'amorphisation est obtenue par implantation d'ions Si à haute dose et à haute énergie.

A la fin de cette étape d'amorphisation, la zone de canal 18 et les couches 24b, 26b sont cristallines.

Lorsque l'étape d'amorphisation partielle est terminée, les couches 24b, 26b cristallines de SiGe sont isolées de la région du canal en Si, i.e. elles sont séparées par une zone amorphe. Les couches cristallines 24b, 26b peuvent alors se relaxer et le SiGe reprend son paramètre de maille propre. Cette relaxation est avantageusement facilitée du fait de la position surélevée des blocs 24, 26, en particulier des zones d'accès. Il peut être prévu de chauffer l'ensemble pour faciliter la relaxation des couches cristallines 24b, 26b.

Dans l'exemple représenté sur la figure 1B, la zone de canal 18 s'étend sur toute la largeur de la grille et sous les espaceurs, et les zones amorphes 6a1, 6a2 sont en contact avec les deux faces latérales de la zone de canal 18 au niveau de plans verticaux P contenant les flancs latéraux des espaceurs qui sont opposés aux flancs latéraux en contact avec la grille. Nous verrons en variante qu'une amorphisation sous les espaceurs est envisageable.

L'élément ainsi obtenu est représenté sur la figure 1B.

En variante, on pourrait envisager de réaliser l'amorphisation à l'aide d'au moins une étape d'implantation. L'implantation amorphisante du matériau semi-conducteur des régions semi-conductrices peut être mise en oeuvre à l'aide d'une espèce dopante donneuse d'électrons permettant d'effectuer en outre un dopage de type N, ou à l'aide d'une espèce dopante accepteuse d'électrons permettant d'effectuer un dopage de type P.

Cette implantation peut également être effectuée de manière à doper des parties des régions semi-conductrices situées sous les espaceurs, de part et d'autre de la zone 18 de canal.

Ainsi, en même temps qu'on rend les rend amorphes, on dope des régions d'accès au canal.

Pour réaliser cela, on peut mettre en oeuvre une implantation au moyen d'un faisceau incliné formant un angle non-nul, voire un angle nul, par rapport à une normale au plan principal du substrat (le plan principal du substrat étant un plan défini par un plan passant par ce dernier et parallèle au plan [O,x,y]).

Une implantation avec une dose, par exemple comprise entre 5×10¹³ et 4×10¹⁵, et un angle, par exemple compris entre 0° et 60° permet de d'atteindre et de doper les régions situées sous les espaceurs à proximité de la zone de canal 18.

A l'issue de l'étape d'amorphisation, les zones rendues amorphes s'étendent, dans une direction verticale, de la face supérieure de la couche isolante 4, jusqu'à une hauteur donnée égale à e₁ et qui est inférieure à l'épaisseur E des blocs semi-conducteurs 24, 26. Les zones 24a, 26a sont surmontées par et en contact avec les couches 24b, 26b de matériau semi-conducteur cristallin appartenant aux blocs semi-conducteurs 24, 26 et dont la structure cristalline n'a pas été impactée par l'étape d'amorphisation.

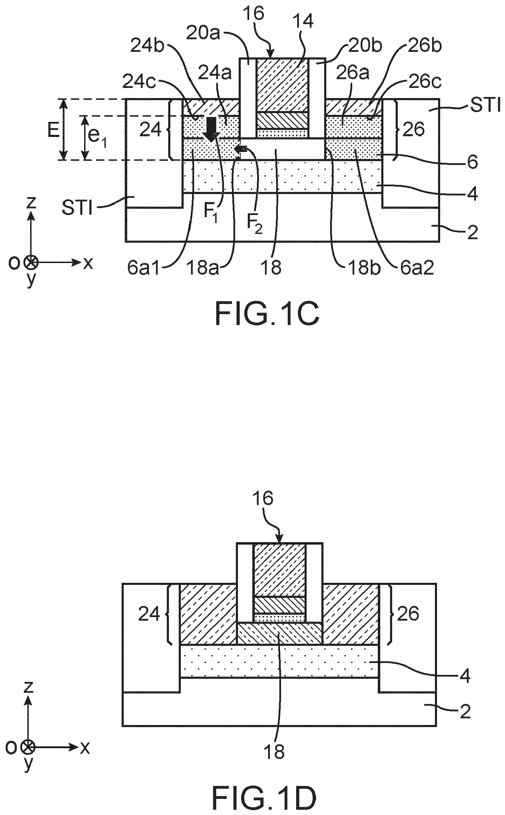

Lors d'une étape suivante, on effectue une recristallisation des zones amorphes par exemple par recuit. Lors de cette étape de recristallisation schématisée sur la figure 1C, deux fronts de recristallisation apparaissent dans chaque région de source et drain:
- un front de recristallisation 24c à partir de la couche 24b et un front de recristallisation 18a à partir d'un flanc de la zone de canal 18;
- un front de recristallisation 26c à partir de la couche 26b et un front de recristallisation 18b à partir de l'autre flanc de la zone de canal 18.

La recristallisation est initiée en appliquant une certaine température à l'élément. Cette température est par exemple comprise entre 400°C et 600°C mais elle pourrait avoir lieu à des températures plus élevées.

Dans la représentation de la figure 1C, le front 24c, dont le déplacement est symbolisé par la flèche F1, progresse verticalement vers le bas et le front 18a de la zone de canal 18, dont le déplacement est symbolisé par la flèche F2, progresse latéralement vers la gauche; le front 26c progresse verticalement vers le bas et l'autre front 18b de la zone de canal 18 progresse latéralement vers la droite.

Les conditions de recristallisation sont telles que le SiGe impose au Si se situant en dessous des zones 24a, 26a le paramètre de maille du SiGe, une contrainte tensile s'applique alors au silicium du canal 18.

L'élément ainsi obtenu est représenté sur la figure 1D.

Pour cela on cherche à obtenir que les fronts de recristallisation 24c, 26c de SiGe se rapprochent le plus possible du canal 18 avant de croiser les fronts 18a, 18b.

De préférence, lors de l'étape d'amorphisation, les couches amorphes 24a, 26a sont très fines de sorte que les fronts de recristallisation 24c, 26c soient proches des zones 6a1, 6a2 en silicium amorphe. On réduit ainsi la distance à parcourir par les fronts 24c, 26c pour commencer à recristalliser le silicium.

Par exemple, dans le cas de zones 24, 26 présentant une épaisseur après épitaxie de 15 nm sur un couche en silicium 6 de 6 nm qui correspond à l'épaisseur du canal 18, on conserve une couche cristalline 24b, 26b de 13 nm d'épaisseur et on forme des zones amorphes 24a, 26a de 2 nm d'épaisseur et des zones amorphes dans la couche 6 au droit des accès de part et d'autre de la zone de canal, de 6 nm d'épaisseur.

De préférence, l'épaisseur totale d'amorphe est comprise entre 8 nm et 18 nm.

De préférence, l'épaisseur de la couche amorphe 24a, 26a est la plus faible possible et est par exemple comprise entre 1 nm et 2 nm.

De préférence également, l'épaisseur de la couche 6 du canal est faible, ce qui permet de ralentir la progression des fronts de recristallisation 18a, 18b.

De manière très avantageuse, en choisissant l'orientation cristallographique des couches cristallines, il est possible de privilégier une direction de cristallisation par rapport à une autre.

Les orientations du canal 18 et des zones cristallines 24b, 26b sont identiques puisque les couches 24b, 26b sont issues d'une croissance par épitaxie sur la couche 6 dans laquelle est formé le canal 18.

En choisissant une orientation du canal 18 <110>, le rapport entre la vitesse de recristallisation effective dans la direction verticale et la vitesse de recristallisation effective dans la direction horizontale est supérieur à 2. En effet, la vitesse de recristallisation dans la direction horizontale est composée de la vitesse de recristallisation selon la direction <110> qui est inférieure à la vitesse selon la direction <100> d'un ordre de deux et d'une vitesse de recristallisation selon la direction <111> qui est inférieure à la vitesse selon la direction <100> d'un ordre de 10.

Ainsi les fronts de recristallisation 24c, 26c progressent au moins deux fois plus vite que les fronts 18a, 18b.

En variante, on peut prévoir de réaliser une amorphisation d'une partie au moins de la zone située sous les espaceurs contrairement à l'amorphisation représentée sur la figure 1B. Cette amorphisation est par exemple obtenue au moyen d'un faisceau incliné. Dans ce cas, lors de la recristallisation, les fronts de recristallisation de la zone de canal présentent une interface avec la couche d'oxyde 10 et une interface avec le matériau des espaceurs 20a et 20b, la recristallisation sous les espaceurs est alors du type <111> alors que la recristallisation du front de SiGe est toujours du type <100>. Le rapport des vitesses est alors de l'ordre de 20 dans des zones de silicium intrinsèque, le front de recristallisation verticale du Si progressant 20 fois plus vite que le front de recristallisation du Si.

La vitesse de recristallisation dans le SiGe à l'interface 24c dépend de la concentration en Ge.

En outre, le choix du matériau des zones de source et drain peut permettre d'obtenir des vitesses des fronts 24c, 26c supérieures à celle des fronts 18a, 18b. Par exemple le SiGe a une vitesse de recristallisation à peu près huit fois supérieure à celle du Si dans la direction <100> à 550°C pour une concentration de Ge de l'ordre de 30%.

Il est également possible d'influencer les vitesses de recristallisation en effectuant un dopage. Le choix du type de dopant, et/ou le choix de la concentration en dopant et/ou le choix de la température de la recristallisation permettent d'accélérer ou au contraire de réduire la vitesse de recristallisation.

Par exemple, le phosphore, l'As, le Sb, le Bore, peuvent être utilisés pour doper les zones à recristalliser. La concentration en dopant à introduire dépend de la température à laquelle on effectue la recristallisation. Au-delà d'une certaine concentration en dopant, la vitesse de recristallisation diminue. Cette limite de concentration dépend du type de dopant et de la température. L'aluminium, le Gallium, l'indium et le Bismuth peuvent être utilisés comme dopants, ils présentent néanmoins une moins bonne solubilité dans le silicium.

Le dopage peut être réalisé lors de la croissance par épitaxie des régions 24 et 26 en ajoutant au mélange de gaz servant à l'épitaxie un gaz contenant le dopant et il est activé pendant l'épitaxie et/ou pendant l'étape d'amorphisation comme cela a été décrit ci-dessus, les dopants étant activés lors de la recristallisation et/ou alors après l'amorphisation.

Les vitesses des fronts de recristallisation peuvent être modélisées à l'aide de logiciels, par exemple le logiciel (Sentaurus Process commercialisé par Synopsys), les paramètres suivants : préfacteurs et énergie d'activation d'une loi d'Arrhenius pour chacune des configurations microscopiques situées sur un plan {100}, {110} ou {111} sont entrés dans le logiciel pour déterminer les vitesses de recristallisation. Ainsi, il est possible de déterminer l'évolution des deux fronts de recristallisation et ainsi de choisir les valeurs des différents paramètres afin que le SiGe ou tout autre matériau adapté impose son paramètre de maille.

Par ailleurs, les transistors adjacents sont séparés par une barrière isolante électrique afin d'éviter un court-circuit entre les transistors. Cette barrière est désignée par STI pour "Shallow Trench Isolation" en terminologie anglaise pour "tranchée d'isolation peu profonde". Des STI sont représentées sur la figure 1A.

Lorsque le matériau du ou des STI est tensile par rapport au matériau des zones de source et drain 24, 26, celui-ci aide à la relaxation du matériau des régions de source et drain déposé par épitaxie.

En revanche si le matériau du ou des STI est compressif par rapport au matériau des régions de source et drain, il est préférable de réduire, voire d'éviter, le contact entre le ou les STI et les régions de source et drain. Pour cela, le niveau de la face supérieure des STI peut être abaissé.

Dans un mode particulièrement avantageux, la concentration en Ge varie lors de croissance de SiGe sur la couche semi-conductrice 6, ce qui permet de localiser très précisément la zone amorphisée de SiGe et donc l'interface entre la zone amorphisée et la zone cristalline.

Pour cela, lors de la réalisation des portions en SiGe sur le Si, on réalise une première couche par épitaxie formée de Siₓ₁Ge_{y1} et une deuxième couche par épitaxie formée de Siₓ₂Ge_{y2}, y1 étant supérieur à y2. La différence de concentration en Ge entre les deux couches est choisie de sorte que, lors de l'amorphisation avec une même dose donnée et une température donnée, outre l'amorphisation de zones de Si située sous le SiGe, seule la couche de Siₓ₁Ge_{y1} "riche en Ge" est amorphisée dans les portions SiGe. La couche de Siₓ₂Ge_{y2} correspond alors à la zone laissée cristalline 24b, 26b et la couche Siₓ₁Ge_{y1} correspond la zone amorphe 24a, 26a. Il est donc possible de réaliser une amorphisation sélective en choisissant y1, y2, la dose et la température. Ainsi l'interface entre la zone amorphisée et la zone restée cristalline est définie par la concentration de Ge et correspond à l'interface des deux couches. Cette interface est alors très précisément localisée et peut présenter une rugosité réduite.

Cette sélectivité dans l'amorphisation est par exemple décrite dans le document« Amorphization threshold in Si implated strained SiGe alloy layers" T.W. Simpson et al. EMRS nov 94, Bost*on.*

Par exemple, la différence entre la concentration en Ge de la zone inférieure et la zone supérieure est de 5%.

L'homme du métier saura obtenir les courbes expérimentales pour déterminer la différence de concentration en Ge, en fonction de la valeur de la dose et de la température pour obtenir une amorphisation sélective.

La présente invention est particulièrement adaptée aux transistors à film mince de silicium totalement déserté sur isolant (FDSOI pour Fully-Depleted Silicon On Insulator en terminologie anglo-saxonne), puisqu'il présente des régions de source et drain surélevées. En outre, il utilise un substrat SOI, le canal et les régions de source et drain étant alors réalisés sur un couche de BOX, ce qui est également favorable pour obtenir une recristallisation selon le paramètre de maille du SiGe prédominante par rapport à des transistors MOS utilisant un substrat bulk.

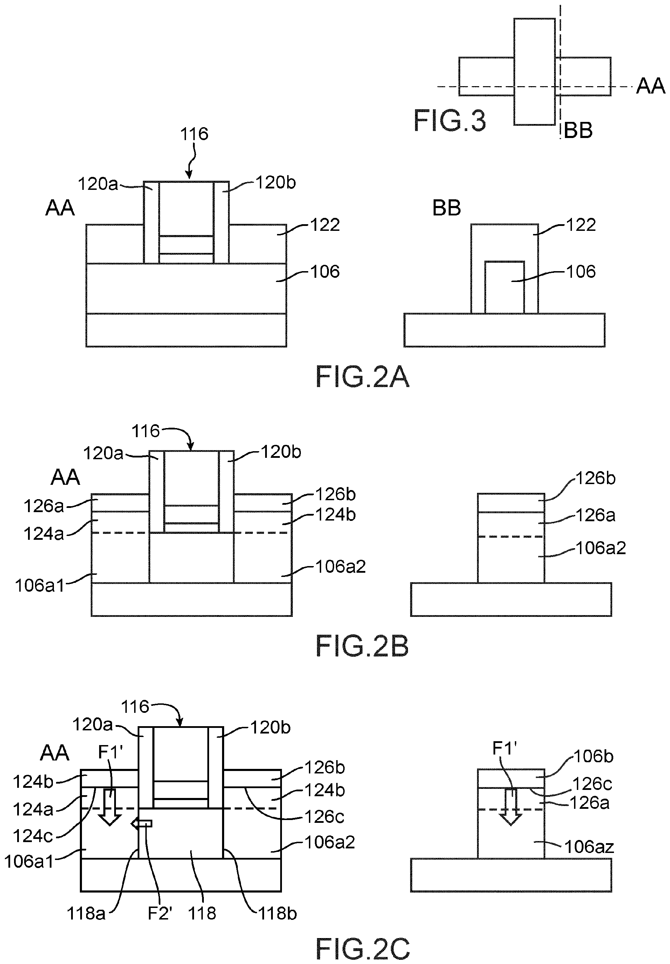

Le procédé selon la présente invention s'applique également aux transistors FinFET (Fin-Shaped Field Effect Transistor). Un exemple d'un tel procédé est représenté sur les figures 2A à 2C. Sur la figure 63, on peut voir le FinFet vu de dessus. Les figures 2A à 2C représentent des vues selon les plans de coupe AA et BB schématisés sur la figure 3.

Les mêmes références que celles des figures 1A à 1C augmentées de 100 sont utilisées pour désigner les mêmes éléments. Par exemple la couche dans laquelle la zone de canal est formée est désignée 106 et le motif de grille est désigné 116.

Sur la figure 2A, on fait croître du matériau semi-conducteur cristallin 122 par épitaxie sur la couche semi-conductrice 106, afin de former avec cette couche semi-conductrice 106,110 des blocs 124, 126 semi-conducteurs cristallins destinés à former des régions de source et de drain à base de matériau semi-conducteur cristallin disposées de part et d'autre de la zone 118 de canal et des espaceurs 120a, 120b.

Dans cet exemple, le matériau semi-conducteur 122 est du SiGe qui présente un paramètre de maille supérieur à celui du silicium.

Lors de la croissance par épitaxie, le SiGe croît suivant le paramètre de maille du silicium et applique alors à la zone de canal 118 une contrainte compressive.

Sur la figure 2B, on applique aux régions 124, 126 une étape d'amorphisation en profondeur de sorte à former en profondeur des zones 124a, 126a de matériau amorphe à partir des régions 124 et 126 et des régions 106a1, 106a2 de matériau amorphe dans la couche 106 et de sorte à conserver une couche de matériau cristallin 124b, 126b au niveau de la partie supérieure libre des régions 124, 126 ou en haut de l'accès. Ces couches de matériau cristallin restantes forment un germe cristallin pour la recristallisation ultérieure.

A la fin de cette étape d'amorphisation, la zone de canal 118 et les couches 124b, 126b sont cristallines.

Lors d'une étape suivante représentée sur la figure 2C, on effectue une recristallisation des zones amorphes par exemple par recuit. Lors de cette étape de recristallisation, deux fronts de recristallisation schématisés par des flèches apparaissent dans chaque région de source et drain:
- un front de recristallisation 124c à partir de la couche 124b et un front de recristallisation 118a à partir d'un flanc de la zone de canal 118;
- un front de recristallisation 126c à partir de la couche 126b et un front de recristallisation 118b à partir de l'autre flanc de la zone de canal 118.

Dans la représentation de la figure 2C, le front 124c, dont le déplacement est symbolisé par la flèche F1', progresse verticalement vers le bas et le front 118a de la zone de canal 118, dont le déplacement est symbolisé par la flèche F2', progresse latéralement vers la gauche; le front 126c progresse verticalement vers le bas et l'autre front 118b de la zone de canal 118 progresse latéralement vers la droite.

Les conditions de recristallisation sont telles que le SiGe impose au Si se situant en dessous des zones 124a, 126a le paramètre de maille du SiGe, une contrainte tensile s'applique alors au silicium du canal 18.

La présente invention présente également un intérêt pour contraindre un canal de transistor en matériau III-V. Par exemple dans le cas d'un transistor sur isolant avec un canal en InGaAs, on pourra réaliser une épitaxie avec une concentration d'Indium plus importante dans l'épitaxie pour avoir une contrainte compressive et utiliser le procédé selon l'invention (amorphisation et recristallisation) pour créer la contrainte tensile dans le NMOS et inversement.

D'autres matériaux pour le canal et pour les zones source et drain peuvent être choisis.

Dans le cas d'un canal en germanium ou SiGe, pour apporter la contrainte tensile on réalise des zones de source et drain par épitaxie de SiGe avec une concentration de Ge plus faible que dans le canal. En variante, pour appliquer une contrainte compressive, le GeSn pourrait être utilisé pour l'épitaxie.

Grâce à l'invention, on peut choisir le matériau dont l'épitaxie est la plus simple à réaliser, et en fonction de la contrainte compressive ou tensile apportée lors de l'épitaxie, les étapes d'amorphisation et de recristallisation ont lieu sur le NMOS ou le PMOS pour appliquer l'autre contrainte tensile ou compressive.

L'invention permet de simplifier la réalisation simultanée de transistors de type N et de type P. En effet, il est avantageusement possible de mettre en oeuvre une épitaxie de SiGe et plus généralement d'un matériau compressif pour appliquer à la fois une contrainte compressive pour réaliser des transistors de type P et une contrainte tensile pour réaliser des transistors de type N. Pour appliquer une contrainte compressive au canal, on effectue uniquement une épitaxie de SiGe dans le cas d'un canal en Si, et pour appliquer une contrainte tensile au canal on applique le procédé selon l'invention. Il n'est alors plus nécessaire de protéger les zones N pendant l'épitaxie sur les zones P et inversement, cette protection étant généralement réalisée par dépôt d'un film de nitrure qui doit ensuite être retiré. Il est également possible de mettre en oeuvre une épitaxie d'un même matériau tensile pour appliquer une contrainte tensile pour réaliser des transistors de type P et pour appliquer une contrainte compressive pour réaliser des transistors de type N.

Le procédé de fabrication des CMOS est donc simplifié.

Néanmoins, un procédé de réalisation de CMOS mettant en oeuvre deux épitaxies différentes pour les zones N et les zones P ne sort pas du cadre de la présente invention. Par exemple on peut envisager d'appliquer le procédé selon l'invention pour appliquer une contrainte tensile par exemple à partir d'une épitaxie de SiGe et d'appliquer le procédé selon l'invention pour appliquer un contrainte compressive par exemple à partir d'une épitaxie de SiC.

## Revendications

1. Procédé de réalisation d'un transistor sur une couche (6) en un premier matériau semi-conducteur cristallin pour la réalisation d'un canal (18), déposée sur une couche de diélectrique (4), le procédé comportant les étapes:
a) de croissance par au moins une épitaxie de zones en un deuxième matériau semi-conducteur sur la couche en un premier matériau semi-conducteur cristallin (6), de sorte à former des blocs de source et de drain (24, 26) avec la couche en un premier matériau semi-conducteur cristallin (6) de part et d'autre du canal (18), le deuxième matériau semi-conducteur ayant un paramètre de maille différent de celui du premier matériau semi-conducteur,
b) amorphisation en profondeur d'une partie (24a, 26a) des zones en un deuxième matériau semi-conducteur de sorte à ne conserver qu'une couche (24b, 26b) de deuxième matériau semi-conducteur cristallin en surface des blocs de source et de drain (24, 26), et amorphisation d'au moins les zones (6a, 6b) de la couche en un premier matériau semi-conducteur (6) situées sous les zones en deuxième matériau semi-conducteur,
c) recristallisation des blocs de source et de drain (24, 26) de sorte que le deuxième matériau semi-conducteur impose son paramètre de maille aux zones de source et de drain.

2. Procédé de réalisation d'un transistor selon la revendication 1, dans lequel l'orientation cristalline de la couche en un premier matériau semi-conducteur (6) est <100>.

3. Procédé de réalisation d'un transistor selon la revendication 2, comportant une étape de réalisation d'une grille (16) sur la couche en un premier matériau semi-conducteur et d'espaceurs (20a, 20b) entre la grille (16) et les zones en un deuxième matériau semi-conducteur, dans lequel lors de l'étape d'amorphisation des zones de la couche en un premier matériau semi-conducteur, les zones en un premier matériau semi-conducteur situées sous les espaceurs sont également rendues amorphes.

4. Procédé de réalisation d'un n transistor selon l'une des revendications 1 à 3, dans lequel une étape de dopage a lieu avant, pendant ou après l'étape d'amorphisation et avant l'étape de recristallisation et/ou dans lequel le ou les dopants sont choisis parmi le phosphore, l'arsenic, l'antimoine et le bore.

5. Procédé de réalisation d'un transistor selon l'une des revendications 1 à 4, dans lequel la température de recristallisation est comprise entre 400°C et 600°C.

6. Procédé de réalisation d'un transistor selon l'une des revendications 1 à 5, dans lequel l'épaisseur des zones amorphes (24a, 26a) en un deuxième matériau semi-conducteur est comprise entre 1 nm et 2 nm.

7. Procédé de réalisation d'un transistor selon l'une des revendications 1 à 6, dans lequel le transistor réalisé est un transistor de type N et dans lequel le deuxième matériau semi-conducteur a un paramètre de maille plus grand que celui du premier matériau semi-conducteur, par exemple le premier matériau semi-conducteur étant du Si et le deuxième matériau semi-conducteur étant du SiₓGe_{y}.

8. Procédé de réalisation d'un transistor selon la revendication 7, dans lequel lors de l'étape a) deux sous-étapes de croissance par épitaxie ont lieu, une première sous-étape de croissance lors de laquelle une première portion de Siₓ₁Ge_{y1} est formée, et une deuxième sous-étape lors de laquelle une deuxième portion de Siₓ₂Ge_{y2} est formée, y1 étant supérieure à y2, et dans lequel, lors de l'étape b), pour une dose donnée et une température donnée, au moins les zones (6a, 6b) de la couche en silicium situées sous les zones en Siₓ₁Ge_{y1} sont amorphisées et y1 et y2 sont choisis de sorte que seule la première portion de Siₓ₁Ge_{y1} parmi les première Siₓ₁Ge_{y1} et deuxième portions Siₓ₂Ge_{y2} soit amorphisée.

9. Procédé de réalisation d'un transistor selon l'une des revendications 1 à 6, dans lequel le transistor réalisé est un transistor de type P et dans lequel le deuxième matériau semi-conducteur a un paramètre de maille plus petit que celui du premier matériau semi-conducteur.

10. Procédé de réalisation d'un transistor selon l'une des revendications 1 à 7 ou 9, dans lequel le premier matériau et le deuxième matériau sont des semi-conducteurs III-V, par exemple en InGaAs.

11. Procédé de réalisation d'un transistor selon l'une des revendications 1 à 10, dans lequel la couche en un premier matériau semi-conducteur et la couche en un matériau diélectrique appartiennent à un substrat SOI.

12. Procédé de réalisation d'un transistor selon l'une des revendications 1 à 11, dans lequel le transistor à réaliser est un FDSOI ou un FinFet.

13. Procédé de réalisation de plusieurs transistors séparés par des barrières isolantes électriques, dans lequel les transistors sont réalisés suivant le procédé selon l'une des revendications 1 à 12, et dans lequel la face libre des matériaux des barrières isolantes électriques est abaissée de sorte à réduire le contact entre les barrières isolantes électrique et les zones en un deuxième matériau semi-conducteur.

14. Procédé de réalisation d'un ensemble de transistors de type N et de type P, dans lequel la réalisation des transistors de type N est faite selon le procédé selon la revendication 7 ou 8 et dans lequel lors de la réalisation des transistors de type P, les blocs de source et de drain sont obtenus directement par croissance par épitaxie du deuxième matériau semi-conducteur simultanément à l'étape de croissance par épitaxie du deuxième matériau semi-conducteur du procédé de réalisation des transistors de type N.

15. Procédé de réalisation d'un ensemble de transistors de type N et de type P, dans lequel la réalisation des transistors de type P est faite selon le procédé selon la revendication 9 et dans lequel lors de la réalisation des transistors de type N, les blocs de source et de drain sont obtenus directement par croissance par épitaxie du deuxième matériau semi-conducteur simultanément à l'étape de croissance par épitaxie du deuxième matériau semi-conducteur du procédé de réalisation des transistors de type P.

## Patentansprüche

1. Verfahren zur Herstellung eines Transistors auf einer Schicht (6) aus einem ersten kristallinen Halbleitermaterial für die Herstellung eines Kanals (18), aufgebracht auf einer dielektrischen Schicht (4), wobei das Verfahren die Schritte umfasst:
a) Aufwachsen durch wenigstens eine Epitaxie von Bereichen aus einem zweiten Halbleitermaterial auf der Schicht aus einem ersten kristallinen Halbleitermaterial (6), so dass mit der Schicht aus einem ersten kristallinen Halbleitermaterial (6) zu beiden Seiten des Kanals (18) Source- und Drain-Blöcke (24, 26) gebildet werden, wobei das zweite Halbleitermaterial einen Gitterparameter hat, der verschieden von demjenigen des ersten Halbleitermaterials ist,
b) Amorphisierung in der Tiefe von einem Teil (24a, 26a) der Bereiche aus einem zweiten Halbleitermaterial, so dass nur eine Schicht (24b, 26b) aus dem zweiten kristallinen Halbleitermaterial an der Oberfläche der Source-und Drain-Blöcke (24, 26) übrig bleibt, und Amorphisierung von wenigstens den Bereichen (6a, 6b) der Schicht aus einem ersten Halbleitermaterial (6), die sich unter den Bereichen aus dem zweiten Halbleitermaterial befinden,
c) Rekristallisierung der Source- und Drain-Blöcke (24, 26), so dass das zweite Halbleitermaterial seinen Gitterparameter den Source- und Drain-Bereichen aufzwingt.

2. Verfahren zur Herstellung eines Transistors nach Anspruch 1, wobei die kristalline Orientierung der Schicht aus einem ersten Halbleitermaterial (6) <100> ist.

3. Verfahren zur Herstellung eines Transistors nach Anspruch 2, umfassend einen Schritt der Herstellung eines Gates (16) auf der Schicht aus einem ersten Halbleitermaterial und von Abstandhaltern (20a, 20b) zwischen dem Gate (16) und den Bereichen aus einem zweiten Halbleitermaterial, wobei bei dem Schritt der Amorphisierung der Bereiche der Schicht aus einem ersten Halbleitermaterial auch die Bereiche aus einem ersten Halbleitermaterial, die sich unter den Abstandhaltern befinden, amorph gemacht werden.

4. Verfahren zur Herstellung eines Transistors nach einem der Ansprüche 1 bis 3, wobei ein Dotierungsschritt vor, während oder nach dem Schritt der Amorphisierung und vor dem Schritt der Rekristallisierung stattfindet, oder/und wobei der Dotierstoff oder die Dotierstoffe ausgewählt sind aus Phosphor, Arsen, Antimon und Bor.

5. Verfahren zur Herstellung eines Transistors nach einem der Ansprüche 1 bis 4, wobei die Rekristallisierungstemperatur zwischen 400°C und 600°C liegt.

6. Verfahren zur Herstellung eines Transistors nach einem der Ansprüche 1 bis 5, wobei die Dicke der amorphen Bereiche (24a, 26a) aus einem zweiten Halbleitermaterial zwischen 1 nm und 2nm liegt.

7. Verfahren zur Herstellung eines Transistors nach einem der Ansprüche 1 bis 6, wobei der hergestellte Transistor ein Transistor vom N-Typ ist, und wobei das zweite Halbleitermaterial einen Gitterparameter hat, der größer ist als derjenige des ersten Halbleitermaterials, wobei beispielsweise das erste Halbleitermaterial Si ist und das zweite Halbleitermaterial SiₓGe_{y} ist.

8. Verfahren zur Herstellung eines Transistors nach Anspruch 7, wobei beim Schritt a) zwei Unterschritte des epitaktischen Aufwachsens stattfinden, ein erster Unterschritt des Aufwachsens, bei dem ein erster Abschnitt aus Siₓ₁Ge_{y1} gebildet wird, und ein zweiter Unterschritt, bei dem ein zweiter Abschnitt aus Siₓ₂Ge_{y2} gebildet wird, wobei y1 größer ist als y2, und wobei beim Schritt b) für eine gegebene Dosis und eine gegebene Temperatur, wenigstens die Bereiche (6a, 6b) der Schicht aus Silizium, die sich unter den Bereichen aus Siₓ₁Ge_{y1} befinden, amorphisiert werden, und y1 und y2 so ausgewählt werden, dass nur der erste Abschnitt aus Siₓ₁Ge_{y1} aus dem ersten Abschnitt Siₓ₁Ge_{y1} und dem zweiten Abschnitt Siₓ₂Ge_{y2} amorphisiert wird.

9. Verfahren zur Herstellung eines Transistors nach einem der Ansprüche 1 bis 6, wobei der hergestellte Transistor ein Transistor vom P-Typ ist, und wobei das zweite Halbleitermaterial einen Gitterparameter aufweist, der kleiner ist als der des ersten Halbleitermaterials.

10. Verfahren zur Herstellung eines Transistors nach einem der Ansprüche 1 bis 7 oder 9, wobei das erste Material und das zweite Material III-V Halbleiter sind, etwa aus InGaAs.

11. Verfahren zur Herstellung eines Transistors nach einem der Ansprüche 1 bis 10, wobei die Schicht aus einem ersten Halbleitermaterial und die Schicht aus einem dielektrischen Material zu einem SOI Substrat gehören.

12. Verfahren zur Herstellung eines Transistors nach einem der Ansprüche 1 bis 11, wobei der herzustellende Transistor ein FDSOI oder ein FinFet ist.

13. Verfahren zur Herstellung mehrerer Transistoren, die durch elektrisch isolierende Barrieren getrennt sind, wobei die Transistoren gemäß dem Verfahren nach einem der Ansprüche 1 bis 12 hergestellt werden, und wobei die freie Seite der Materialien der elektrisch isolierenden Barrieren abgesenkt wird, so dass der Kontakt zwischen den elektrisch isolierenden Barrieren und den Bereichen aus einem zweiten Halbleitermaterial reduziert wird.

14. Verfahren zur Herstellung einer Anordnung von Transistoren vom N-Typ und vom P-Typ, wobei die Herstellung der Transistoren vom N-Typ nach dem Verfahren gemäß Anspruch 7 oder 8 ausgeführt wird, und wobei bei der Herstellung der Transistoren vom P-Typ die Source- und Drain-Blöcke direkt durch epitaktisches Aufwachsen des zweiten Halbleitermaterials gleichzeitig zum Schritt des epitaktischen Aufwachsens des zweiten Halbleitermaterials des Verfahrens zur Herstellung der Transistoren vom N-Typ erhalten werden.

15. Verfahren zur Herstellung einer Anordnung von Transistoren vom N-Typ und vom P-Typ, wobei die Herstellung der Transistoren vom P-Typ nach dem Verfahren gemäß Anspruch 9 ausgeführt wird, und wobei bei der Herstellung der Transistoren vom N-Typ, die Source- und Drain-Blöcke direkt durch epitaktisches Aufwachsen des zweiten Halbleitermaterials gleichzeitig zum Schritt des epitaktischen Aufwachsens des zweiten Halbleitermaterials des Verfahrens zur Herstellung der Transistoren vom P-Typ erhalten werden.

## Claims

1. Method of manufacturing a transistor on a layer (6) made of a first crystalline semiconducting material to make a channel (18), deposited on a dielectric layer (4), the method including the following steps:
a) growth of zones made of a second semiconducting material on the layer made of a first crystalline semiconducting material (6) by at least one epitaxy, so as to form source and drain blocks (24, 26) with the layer made of a first crystalline semiconducting material (6) on each side of the channel (18), the second semiconducting material having a lattice parameter different from that of the first semiconducting material,
b) in-depth amorphisation of part (24a, 26a) of zones made of a second semiconducting material so as to keep only one layer (24b, 26b) of the second crystalline semiconducting material on the surface of the source and drain blocks (24, 26), and amorphisation of at least the zones (6a, 6b) of the layer made of a first semiconducting material (6) located under zones made of a second semiconducting material,
c) recrystallisation of the source and drain blocks (24, 26) such that the second semiconducting material imposes its lattice parameter on the source and drain zones.

2. Method of manufacturing a transistor according to claim 1, in which the crystalline orientation of the layer made of a first semiconducting material (6) is <100>.

3. Method of manufacturing a transistor according to claim 2, comprising a step to make a gate (16) on the layer made of a first semiconducting material and spacers (20a, 20b) between the gate (16) and zones made of a second semiconducting material, in which during the amorphisation step of the zones made of the layer made of a first semiconducting material, the zones made of a first semiconducting material located under the spacers are also made amorphous.

4. Method of manufacturing a transistor according to one of claims 1 to 3, in which a doping step takes place before, during or after the amorphisation step and before the recrystallisation step and/ or in which the dopant(s) is (are) chosen from among phosphorus, arsenic, antimony and boron.

5. Method of manufacturing a transistor according to one of claims 1 to 4, in which the recrystallisation temperature is between 400°C and 600°C.

6. Method of manufacturing a transistor according to one of claims 1 to 5, in which the thickness of amorphous zones (24a, 26a) made of a second semiconducting material is between 1 nm and 2 nm.

7. Method of manufacturing a transistor according to one of claims 1 to 6, in which the transistor made is an N type transistor and the second semiconducting material has a lattice parameter larger than the lattice parameter of the first semiconducting material, for example the first semiconducting material being Si and the second semiconducting material being SiₓGe_{y}.

8. Method of manufacturing a transistor according to claim 7, in which two epitaxy growth sub-steps take place during step a), a first growth sub-step during which a first portion of Siₓ₁Ge_{y1} is formed, and a second sub-step during which a second portion of Siₓ₂Ge_{y2} is formed, where y1 is greater than y2, and in which during step b), for a given dose and a given temperature, at least the zones (6a, 6b) of the silicon layer located under the Siₓ₁Ge_{y1} zones are amorphised and y1 and y2 are chosen such that only the first portion of Siₓ₁Ge_{y1} among the first Siₓ₁Ge_{y1} and second Siₓ₂Ge_{y2} portions is amorphised

9. Method of manufacturing a transistor according to one of claims 1 to 6, in which the transistor made is a P type transistor in which the lattice parameter of the second semiconducting material is smaller than the lattice parameter of the first semiconducting material.

10. Method of manufacturing a transistor according to one of claims 1 to 7 or 9, in which the first material and the second material are III-V semiconducting materials, for example they are made of InGaAs.

11. Method of manufacturing a transistor according to one of claims 1 to 10, in which the layer made of a first semiconducting material and the layer made of a dielectric material form part of an SOI substrate.

12. Method of manufacturing a transistor according to one of claims 1 to 11, in which le transistor to be made is an FDSOI or an FinFet.

13. Method of manufacturing several transistors separated by electrical isolating barriers in which the transistors are made using the method according to one of claims 1 to 12, and in which the free face of the materials from which the electrical isolating barriers are made is lowered so as to reduce contact between the electrical isolating barriers and the zones made of a second semiconducting material.

14. Method of manufacturing a set of N type and P type transistors in which the N type transistors are made using the method according to claim 7 or 8 and in which the source and drain blocks are made directly during manufacturing of P type transistors by epitaxial growth of the second semiconducting material at the same time as the step for epitaxial growth of the second semiconducting material in the method for making N type transistors.

15. Method of making a set of N type and P type transistors in which the P type transistors are made using the method according to claim 9 and in which the source and drain blocks are made directly during manufacturing of N type transistors by epitaxial growth of the second semiconducting material at the same time as the step for epitaxial growth of the second semiconducting material in the method for making P type transistors.
